# EUROPEAN PATENT APPLICATION

(11) **EP 4 757 531 A2**
(43) Date of publication of application: **10.06.2026**
(21) Application number: 25219881.7
(22) Date of filing: 01.12.2025
(51) Int. Cl.: H10D 30/60, H10D 62/17, H10W 10/30

(54) **HIGH POWER SWITCH WITH IMPROVED AVALANCHE BREAKDOWN VOLTAGE USING WELL BLOCKING**

(30) Priority: 09.12.2024 US 202418974061
(71) Applicant: NXP B.V., 5656 AG Eindhoven (NL)
(72) Inventor: NISSIM, Brian Jacob, 5656AG Eindhoven (NL); DINH, Viet Thanh, 5656AG Eindhoven (NL); CARNU, Ovidiu, 5656AG Eindhoven (NL); PIJPER, Ralf Maria Theodoor, 5656AG Eindhoven (NL)
(74) Representative: Schwarzweller, Thomas

(57) **Abstract**

A high power switch is described with improved avalanche breakdown voltage using well blocking. In an example, a semiconductor switch includes a substrate of a first type, a deep well of a second type over the substrate, an inner well of the first type over the deep well, a gate over the top surface and over the inner well, a source over the inner well having a contact of a second type coupled to the gate through the inner well, and a drain over the inner well having a contact of the second type coupled to the gate through the inner well. An inner moat is outside of the inner well and over the deep well surrounding the gate, the source, the drain, and the body electrode. An outer moat is outside the deep well over the substrate and surrounding a contact well.

## Description

### BACKGROUND

Semiconductor devices are continuously called to do more with less power in a smaller size. Many of the advances in size and power have come by reducing the size of the transistors and other components of a semiconductor device. This not only allows more transistors to fit into a smaller space on a semiconductor die. It also allows the voltage and total power to be reduced when signals traverse shorter distances through smaller components. The size of the features in the semiconductor is often expressed as a process node named terms of nanometers (nm). Designations of 40nm to 28nm to 16nm to 7nm to now 5nm or 3nm are used to describe increasingly smaller transistors and increasingly more dense circuit placement. Additional advances come from using different component configurations, such as FinFET in which a Field Effect Transistor (FET) is built on a vertical fin a configuration which allows transistors to be placed closer together or Fully Depleted Silicon on Insulator (FDSOI) a configuration which improves electrostatic control.

Ever smaller transistors operating at lower power provide great benefits for digital processing, storage, modulating and other digital functions. However, there are some functions that require more power, e.g., when the digital circuit drives an analog system, such as an actuator, sensor, communications interface, or radio. Wired data communication interfaces may require ±1V or ±2.5V, some physical interfaces require ±5V and a radio transmitter may require ±10V or more. These power levels overwhelm a standard transistor fabricated at a small process node such as 22nm, 16nm or less. In many cases switches for such high voltages are fabricated separately on a different die. The high-power switches may be fabricated at a larger process node and using a different transistor technology which can sustain high voltages, e.g., discrete Micro ElectroMechanical Systems (MEMS), Pseudomorphic High Electron Mobility Transistor (PHEMT), p-type, intrinsic, n-type (PIN) diodes, or GaAs Metal Semiconductor Field Effect Transistor (MESFET) devices.

### SUMMARY

A high power switch is described with improved avalanche breakdown voltage using well blocking. In an example, a semiconductor switch includes a substrate of a first type, a deep well of a second type over the substrate, an inner well of the first type over the deep well, a gate over the top surface and over the inner well, a source over the inner well having a contact of a second type coupled to the gate through the inner well, and a drain over the inner well having a contact of the second type coupled to the gate through the inner well, a drain over the inner well having a contact of the second type coupled to the gate through the inner well. A body electrode is over the inner well having a contact of the first type coupled to the gate through the inner well. An inner moat is outside of the inner well and over the deep well surrounding the gate, the source, the drain, and the body electrode. A deep well contact is outside of the inner moat and over the deep well having a contact of the second type and a contact well of the second type, the contact well surrounding the inner well, wherein the gate, the source, the drain, the body electrode, and the inner moat are over the deep well, and an outer moat is outside the deep well over the substrate and surrounding the contact well.

In some embodiments, the inner moat and the outer moat are comprised of a substrate material of the first type.

In some embodiments, the deep well is a deep N-Well, the inner well is a P-Well, and wherein the inner moat and the outer moat comprise p-type substrate.

In some embodiments, the body electrode is coupled to the source.

Some embodiments further include an isolation layer over the inner moat and over the outer moat.

In some embodiments, the isolation layer comprises a shallow trench isolation layer.

In some embodiments, the inner moat is configured as an effective diode with an anode at the inner well and a cathode at the contact well to increase a breakdown voltage of the semiconductor switch in the deep well.

In some embodiments, the outer moat is configured as an effective diode with a cathode at the contact well to increase the breakdown voltage of the semiconductor switch.

Some embodiments further include a substrate electrode outside of the outer moat and an outer well of the first type over the substrate, the outer well surrounding the outer moat.

In some embodiments, the body electrode is coupled to the substrate electrode, the semiconductor switch further comprising a capacitor coupled between the body electrode and the source configured to balance the voltage between the body electrode and the source.

Some embodiments further include a second capacitor between the deep well contact and the substrate electrode configured to reduce voltage stress across the outer moat.

Some embodiments further include a floating well of the first type over the substrate inside the outer moat and outside of the contact well, the floating well to divide the outer moat into the outer moat and a middle moat.

In some embodiments, the body electrode is coupled to the substrate electrode and wherein the body electrode is coupled to the substrate electrode, the semiconductor switch further comprising a capacitor coupled between the body electrode and the source configured to balance a voltage between the body electrode and the source, and a second capacitor between the deep well contact and the floating well.

In some embodiments, the gate covers a channel of intrinsic undoped silicon over a buried oxide layer, the buried oxide layer being over the inner well.

In an example, a semiconductor switch includes a P substrate having a top surface over a bottom surface that is opposite the top surface, a deep N-Well over the P substrate, an inner P-Well over the deep N-Well, a gate over the top surface and over the inner P-Well, a source over the inner P-Well having a contact coupled to the gate through the inner P-Well, a drain over the inner P-Well having a contact coupled to the gate through the inner P-Well, a body electrode over the inner P-Well having a contact coupled to the gate through the inner P-Well, an inner moat formed of the P substrate outside of and over the deep N-Well, the inner moat surrounding the gate, the source, the drain, the body electrode, and the inner P-Well, an N-type contact well surrounding the inner P-Well and the inner moat, wherein the gate, the source, the drain, the body electrode, and the inner moat are over the deep N-Well, an outer moat formed of the P substrate outside the deep N-Well over the substrate, and a P-type floating well inside of the outer moat and outside of the N-type contact well over the P substrate to divide the outer moat into the outer moat and a middle moat.

Some embodiments further include a first capacitor coupled between the source and the inner P-Well, and a second capacitor coupled between the N-type contact well and the P-type contact well.

In some embodiments, the gate covers a SiGe material over a buried oxide layer, the buried oxide layer being over the inner P-Well.

In an example, radio transceiver includes a power amplifier configured to amplify a modulated data signal, an antenna pin coupled to the power amplifier and configured to couple the modulated data signal to an aerial, a low noise amplifier coupled to the antenna pin configured for reception of a wireless data signal from the aerial through the antenna pin, a transmit/receive switch between the power amplifier and the antenna pin configured to connect and disconnect the power amplifier and the antenna pin, the transmit/receive switch comprising: a substrate of a first type having a top surface over a bottom surface that is opposite the top surface; a deep well of a second type over the substrate; an inner well of the first type over the deep well; a gate over the top surface and over the inner well; a source over the inner well having a contact of a second type coupled to the gate through the inner well; a drain over the inner well having a contact of the second type coupled to the gate through the inner well; a body electrode over the inner well having a contact of the first type coupled to the gate through the inner well; an inner moat outside of the inner well and over the deep well surrounding the gate, the source, the drain, and the body electrode; a deep well contact outside of the inner moat and over the deep well having a contact of the second type and a contact well of the second type, the contact well surrounding the inner well, wherein the gate, the source, the drain, the body electrode, and the inner moat are over the deep well; and an outer moat outside the deep well over the substrate and surrounding the contact well.

Some embodiments further include a substrate electrode outside of the outer moat and having a substrate electrode of the first type, an outer well of the first type over the substrate, the outer well surrounding the outer moat, wherein the body electrode is coupled to the substrate electrode, and a capacitor coupled between the body electrode and the source configured to balance the voltage between the body electrode and the source.

Some embodiments further include a resistor between the body electrode and the substrate electrode.

Other aspects in accordance with the invention will become apparent from the following detailed description, taken in conjunction with the accompanying drawings, illustrated by way of example of the principles of the invention.

### BRIEF DESCRIPTION OF THE DRAWINGS

Fig. 1 is a diagram of radio transceiver that includes a high-power semiconductor switch.
Fig. 2 is a cross-sectional diagram of a high-power switch with a DNW and a double blocking mask.
Fig. 3 is a cross-sectional diagram of a high-power switch as in Fig. 2 with added balancing capacitors and isolation resistors.
Fig. 4 is a cross-sectional diagram of a high-power switch with a DNW and a triple blocking mask.
Fig. 5 is a cross-sectional diagram of a high-power switch with a DNW and a triple blocking mask as in Fig. 4 with added balancing capacitors and isolation resistors.
Fig. 6 is a cross-sectional diagram of a high-power switch in the form of an NMOS transistor formed in FDSOI technology over a DNW with a double blocking mask.
Fig. 7 is a cross-sectional diagram of a high-power switch in the form of a PMOS transistor formed in FDSOI technology over a DNW with a double blocking mask.

### DETAILED DESCRIPTION

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure but is merely representative of various embodiments. While the various aspects of the embodiments are presented in drawings, the drawings are not necessarily drawn to scale unless specifically indicated.

The present invention may be embodied in other specific forms without departing from its essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment," "an embodiment," or similar language means that a particular feature, structure, or characteristic described in connection with the indicated embodiment is included in at least one embodiment of the present invention. Thus, the phrases "in one embodiment," "in an embodiment," and similar language throughout this specification may, but do not necessarily, all refer to the same embodiment.

With more advanced scaled semiconductor fabrication technologies such as 16nm to 5nm FinFET or 22nm to 12nm FDSOI, the avalanche breakdown voltages of Deep N-Well (DNW) junctions in transistors and diodes decrease. When a comparatively large Alternating Current (AC) voltage swing is applied through such a small device, there can be an unwanted current flow through parasitic DNW junction diodes or substrate taps. When voltage swings are on the order of the well junction avalanche breakdown voltage, the diode can conduct current. Similarly, a large Direct Current (DC) voltage may also overcome the well junction avalanche breakdown voltage. This conduction can create performance failures due to highly non-linear and lossy shunt current and can also create damage leading to functional failures.

A high-power switch with a corresponding high avalanche breakdown voltage in the well junction is described herein that can be fabricated on small process nodes. The high-power switch overcomes the low breakdown voltages of the well junctions in these advanced small processes. It can be fabricated in these nodes without using any special mask layer. A transistor switch may be configured on a substrate of a first type over a deep well of a second type. A body electrode over the inner well of the switch has a contact of the first type coupled to the gate through the inner well. An inner moat outside of the inner well and over the deep well surrounds the gate, the source, the drain, and the body electrode. A deep well contact outside of the first block and over the deep well has a contact of the second type and a contact well of the second type, the contact well surrounding the inner well. The gate, the source, the drain, the body electrode, and the first block are over the DNW. To further improve the breakdown voltage an outer moat outside the deep well, over the substrate, surrounds the contact well. As a result, the DNW may be biased above what would otherwise be the breakdown voltage to enhance the high-power performance of a switch or other semiconductor device.

In this structure, a P-well blocking mask in the form of an inner moat inside and an outer moat outside of the high voltage swing DNW structures, e.g., a triple P-Well blocking structure, to selectively increase the DNW avalanche breakdown voltages. The P-Well blocking structure may also be used to increase the impedance of the substrate surrounding the DNW structure to reduce the voltage stress across the DNW-P-Well junctions. Resistors and balancing capacitors can be selected and positioned to optimally balance voltage stress across the structure while avoiding over-stressing the resistors and capacitors themselves. The triple P-Well blocking structure increases the voltage swing capacity of a practical integrated FinFET switch by over 300% relative to a conventional DNW structure. This allows an integrated radio frequency (RF) Switch to meet high-power requirements, e.g. 30dBm or more, for a Wi-Fi System-on-a-Chip (SoC) in advanced technology nodes.

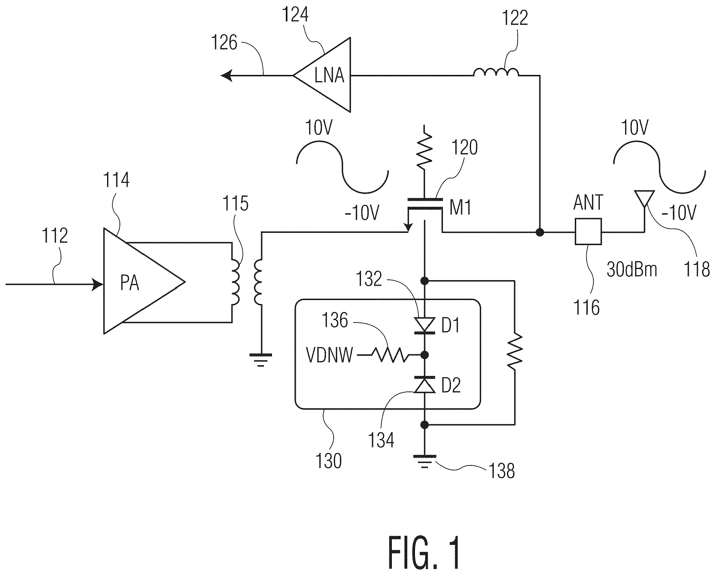

Fig. 1 is a diagram of a radio transceiver that includes a high power switch. As shown, in a radio transceiver a modulated data signal 112 is applied to a power amplifier 114 that is configured to amplify the modulated data signal. The modulated data signal may be measured at fractions of a volt, but the power amplifier output is amplified and on the order of ±10V. The amplified data signal from the power amplifier 114 is provided through a balun 115, and through a Transmit/Receive (T/R) switch 120 to an antenna pin 116 and from the antenna pin 116 to an external aerial 118. For transmission from the power amplifier 114 to the antenna pin 116, the T/R switch is ON or open. This allows for wireless data transmission through the aerial 118. In this way the T/R switch 120 is configured to connect and disconnect the power amplifier 114 and the antenna pin 116.

For reception of a wireless data signal from the aerial 118, through the antenna pin 116. The antenna pin 116 is coupled to a receive inductor 122 that is coupled to a low noise amplifier (LNA) 124. The LNA 124 generates a receive modulated data signal 126 with a low power output suitable for demodulation and processing in low power, high density circuitry. The high-power switch 120 is OFF or closed to route the receive signal away from the output PA 114 and to the receive LNA 124. The LNA 124 generates a receive modulated data signal 126 that is passed to a baseband demodulator for use by the receiver. In this example, a single aerial 118 is used for both transmission and reception. The connected antenna pin 116 is time shared, as with a time-division multiplexed (TDM) protocol, between the transmitter and the receiver. The high-power switch 120 isolates the receive path to the LNA 124 from the parasitic loading of the PA 114 and the balun 115.

The high-power switch 120 is shown as an N-type Metal Oxide Semiconductor (NMOS) transistor with a source coupled to the power amplifier 114 and a drain coupled to the antenna 116. The gate is externally controlled to switch between transmit and receive modes. In other applications, a PMOS or any other suitable type of semiconductor transistor may be used instead. The high-power switch 120 has a Deep N-Well (DNW) 130 below the channel. Other transistor types may have other structures beneath the channel.

The characteristics of the DNW 130 may be described as a first diode 132 and an opposite second diode 134. The first diode 132 has a p-side coupled to a channel of the high-power switch 120 and the n-side coupled to the n-type of the second diode 134. The first diode represents the inherent isolation between the P-Well and the N-Well. The second diode 134 is configured in the opposite direction with the p-side representing the p-type substrate coupled to ground 138 and the n-side coupled to the n-side of the first diode 132. The second diode represents the inherent isolation from the N-Well to the p-type substrate. A bias voltage is used, labeled as VDNW, to bias the N-Well and the DNW 130 in order to ensure that the first diode 132 and the second diode134 are reverse biased. A resistor 136 is coupled between the diodes.

In this example, as in other implementations of a high-power MOS switch, the series switch passes a power signal with a sweep having peak amplitude of as much as 10V. This allows the power amplifier 114 to deliver 30dBm to the antenna pin 116. For many advanced process nodes, an NMOS switch may have a DNW with a lower reverse breakdown voltage. This may be due to a higher doping level in adjacent N-Well and P-Well regions. The first diode 132 and the second diode 134 of the DNW 130 may not be able to sustain the 10V voltage swings and thereby the DNW prevents the switch from passing voltages at 30dBm. Instead, an avalanche breakdown of the junctions of the DNW 130 prematurely clips the 10V signal and damages the DNW structure and possibly other nearby structures. Such failures have been observed in T/R switch designs in both FinFET and FDSOI processes.

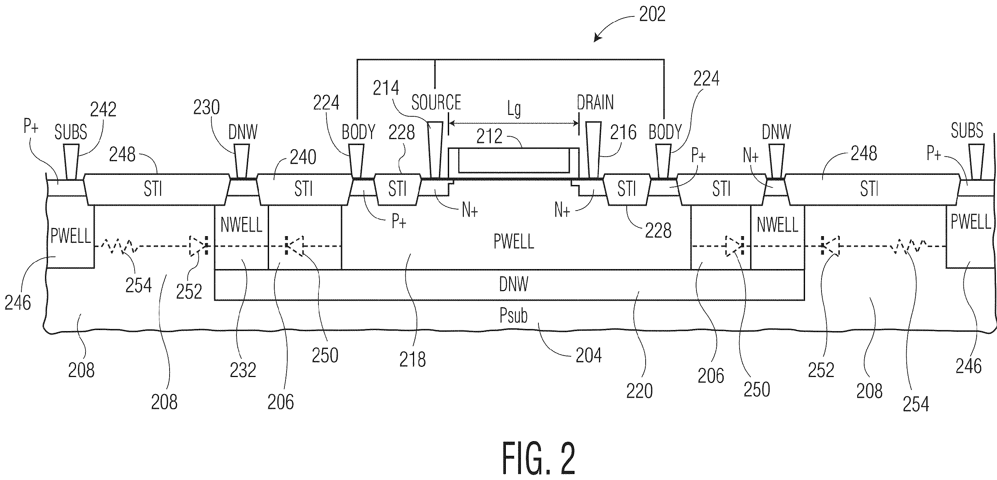

Fig. 2 is a cross-sectional diagram of a high-power switch with a deep N-well (DNW) and a double blocking mask to increase the avalanche breakdown voltage of the high-power switch. The structures in the drawing figures are symmetrical so that an inner moat 206 is the same inner moat 206 outside the P-Well 218 on both sides of the P-Well 218. The N-Well 232 outside the inner moat 206 is the same N-Well 232 on both sides of the inner moat 206. In addition, the drawings are cross-sectional such that the inner moat 206, for example, surrounds the P-Well 218 on all sides. The high-power switch 202 is a semiconductor switch formed as an NMOS FET on a p-type substrate 204. The p-type substrate has top surface and a bottom surface. The bottom surface is facing the bottom of the page and opposite the top surface. An inner moat 206 surrounds the high-power switch and an outer moat 208, i.e. a resistance moat, surrounds the inner moat 206, an N-Well 232, and the DNW 220. The high-power switch is shown as an N-type planar Metal-Oxide Semiconductor (MOS) transistor over the top surface of the p-type substrate. While the components are shown as having a planar configuration, the wells, moats, and other structures may be adapted to suit other configurations including FinFET and SOI. In addition, while only one NMOS FET is shown, additional NMOS FET structures may be formed over the high-power switch 202 to increase the power handling ability of the high-power switch 202. While the high-power switch is shown as an NMOS transistor, a P-type MOS transistor may be used instead with corresponding adaptations to the other features shown in the figures.

The high-power switch 202 has a gate 212 over an inner well, in this example an inner P-well 218. The gate 212 is configured between an n-type source 214, that is N+ doped, and an n-type drain 216, that is N+ doped. The gate 212, source 214, and drain 216 are over the P-Well 218, which is over a DNW 220 which is over the p-type substrate 204. The gate 212, source 214 and drain 216 of the high-power switch 202 may be formed on different types of substrates to suit different applications. The substrates may include bulk silicon and silicon-on-insulator. A P-Well 218 may be used underneath this transistor. A DNW 220 is fabricated below the P-Well 218 to isolate the device against the p-type substrate 204.

A p-type body electrode 224 is formed of a P+-doped contact coupled to the P-Well around the source 214, drain 216 and gate 212 over the P-Well 218 and isolated from the source 214 and gate 212 by a Shallow Trench Isolation (STI) layer. The source 214 and the drain 216 may be coupled to higher layers and external components through electrodes consisting of silicide contacts and metal vias. The description with reference to Fig. 2 is directed to planar devices, either bulk or Silicon-on-Insulator. The same device configuration may also be used with other configurations, e.g., a FinFET configuration in which the transistor is formulated in fins. With FinFET, the gate 212 may be configured as wrapping around the fin, while the source 214 and drain 216 are epitaxially grown on the fin.

The sidewall of the inner P-Well 218 is separated from the sidewall of the N-Well 232 by an inner moat 206 of the P substrate or a similar substrate material that surrounds, or extends all around, the inner P-Well 218 and down to the DNW 220. The inner moat 206 blocks inner P-Well doping and instead leaves the material of the P substrate 204 underneath near its intrinsic, low doping concentration. In examples the inner moat 206 is formed in the P substrate with a native layer process to block P-type doping into the inner moat 206 when forming P-Wells and N-Wells. A moat, as used herein, refers to a structure, other than an N-Well or P-Well with such a described intrinsic low doping concentration and that provides electrical blocking effects. An n-type DNW electrode 230 is connected to the N-Well 232 through an N+-doped contact outside of the inner moat 206 and over the N-Well 232. The N-Well 232 extends to the DNW 220. The DNW is then isolated by an outer moat 208 that surrounds and extends all around the DNW 220 and the inner moat 206. A p-type substrate electrode 242 is formed of a P+-doped contact outside of the outer moat 208 over an outer well, in this example an outer P-Well 246 that extends into the P substrate 204 outside the outer moat 208. A surface STI layer 240 isolates the body electrode 224 from the DNW electrode 230 over the inner moat 206. A second surface STI layer 248 isolates the DNW electrode 230 from the substrate electrode 242 over the outer moat 208. The inner moat 206 and the outer moat 208 may be undoped regions of the P substrate 204 between the respective doping wells of the body electrodes 224, the DNW electrodes 230 and the substrate electrodes 242. The inner moat 206 and the outer moat 208 allow lateral implant diffusion and wider depletion width in the substrate.

The body electrodes 224 on both sides of the high-power switch 202 are coupled to the source 214. The connection applies a Direct Current (DC) bias to the body, i.e. the inner P-Well 218. The P+ contact of the body electrode 224, the N+ contact of the source 214, the STI layer 240 and the block between the two may be adjusted in dimensions and characteristics to obtain appropriate intrinsic capacitances of intrinsic well junction diodes 250 within the inner moat 206. Alternatively, the body electrode 224 may be disconnected from the source 214 and instead coupled to a different voltage source to apply an appropriate DC bias to the body.

Additional dielectric and conductive layers may be formed over the structures shown herein to provide electrical and thermal coupling and control. In some configurations, the N+-doped region and/or the P+-doped region can be appropriately doped epitaxial semiconductor material. Different dopants may be used to achieve different conductivity types, and the dopants may vary depending upon different semiconductor materials. For example, a silicon-based semiconductor material (e.g., silicon, silicon germanium, etc.) having N-type conductivity may be doped with an N-type dopant (e.g., a Group V dopant, such as arsenic (As), phosphorous (P) or antimony (Sb)), whereas a silicon-based semiconductor material having P-type conductivity may be doped with a P-type dopant (e.g., a Group III dopant, such as boron (B) or indium (In)). A gallium nitride (GaN)-based semiconductor material that has P-type conductivity may be doped with magnesium (Mg), whereas a gallium nitride (GaN)-based semiconductor material that has N-type conductivity may be doped with silicon (Si).

The inner P-Well 218, inner moat 206, and N-Well 232 form a first effective diode 250, shown as being within the inner moat 206, with an anode at the inner P-Well 218 and a cathode at the N-Well 232 and a body in the inner moat 206 that is formed of the material of the P substrate 204. The first effective diode 250 is represented in Fig. 1 as the first diode 132. Similarly, the second block, which is the outer moat 208, forms a second effective diode 252, shown as being within the outer moat 208, with opposite polarity. The anode of the second effective diode 252 is at the outer P-Well 246 and the cathode of the second diode 252 is at the N-Well 232. The second effective diode 250 is represented in Fig. 1 as the second diode 134. The larger width and depth of the outer moat 208 forms the effective resistor 254 that is represented in Fig. 1 as resistor 136. In the example, as shown, the high breakdown voltage of the inner moat 206 and the outer moat 208 will allow the high-power switch 202 to carry a higher voltage than for a MOSFET switch without the inner moat 206 and the outer moat 208. As used herein, an effective diode or resistor is a diode or resistor that is result of effects of the structure in operation but is not an express component formed in the substrate.

The inner moat 206 provides an intrinsic region between the inner P-Well 218 and the N-Well 232. The outer moat 208 provides an intrinsic region between the N-Well 232 and the nearest substrate, the outer P-Well 246. The inner moat 206 and the outer moat 208 increase the breakdown voltage of the first effective diode 250, an inner diode and the second effective diode 252, an outer diode. Stated another way, the inner moat 206, and the outer moat 208 increase the depletion region width, reducing the electrical field intensity across the junctions. As a result, the DNW 220 isolation structure and surrounding N-Well 232 junction breakdown voltage are increased.

The outer moat 208 has a native substrate layer region that provides a high substrate resistance. The increased substrate resistance of the additional inner and outer moat structures allows for the increase in voltage and voltage swing that is desired for e.g. a T/R Switch, at least in part by reducing the voltage stress. The width of the outer moat 208 may be adjusted to provide the resistance desired for a particular implementation. The resistance 254 reduces the voltage swing across the well junctions.

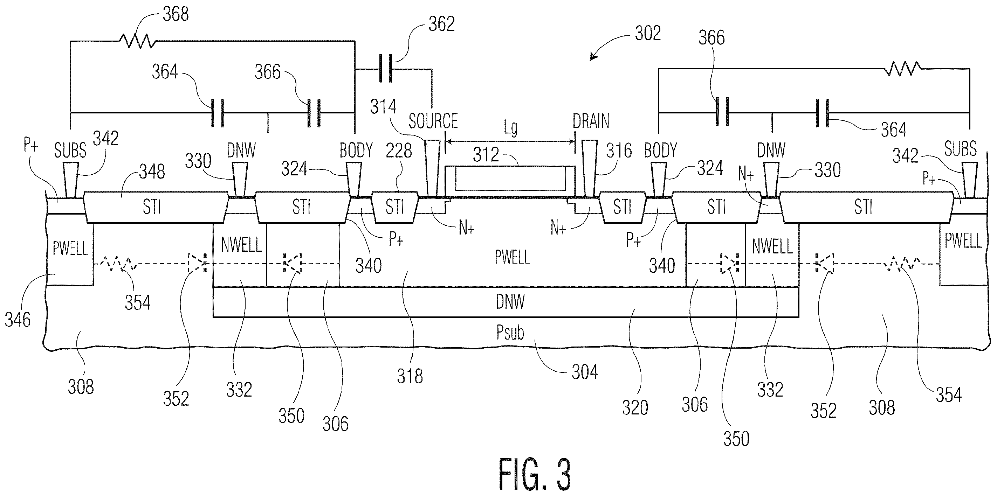

Fig. 3 is a cross-sectional diagram of a high-power switch as in Fig. 2 with added balancing capacitors and isolation resistors. The high-power switch 302 is formed as an NMOS FET on a p-type substrate 304. An inner moat 306 surrounds the high-power switch, and an outer moat 308 surrounds the inner moat 306, an N-Well 332 and the DNW 320. The high-power switch 302 has a gate 312 over a P-well 318. The gate 312 is configured between an n-type source 314, that is N+ doped, and an n-type drain 316, that is N+ doped. The gate 312, source 314, and drain 316 are over the inner P-Well 318, which is over a DNW 320 which is over the p-type substrate 304. A p-type body electrode 324 is formed of a P+-doped contact coupled to the inner P-Well around the source 314, drain 316 and gate 312 over the inner P-Well 318 and isolated from the source 314 by a STI layer over the inner P-Well 318 and around the source 314, drain 316, and gate 312. As in the example of Fig. 2, there may be more or fewer components over and beside those shown. The particular shapes and configurations of components may be adapted to other technologies including FinFET and FDSOI, among others.

The high-power switch has a double P-Well block. The inner P-Well 318 is isolated by an inner moat 306 that extends all around the inner P-Well 318 and down to the DNW 320. The DNW 320 is further isolated by an outer moat 308 that extends all around the DNW 320 and the inner moat 306. A p-type substrate electrode 342 is formed of a P+-doped contact outside of the outer moat 308 over an outer P-Well 346 that extends into the P substrate 304 outside the outer moat 308. A surface STI layer 340 isolates the body electrode 324 from the DNW electrode 330 over the inner moat 306. A second surface STI layer 348 isolates the DNW electrode 330 from the substrate electrode 342 over the outer moat 308. The inner moat 306 and the outer moat 308 allow lateral implant diffusion and wider depletion width in the substrate. As in the example of Fig. 2, additional dielectric and conductive layers may be formed over the structures shown herein to provide electrical and thermal coupling and control.

The body electrodes 324 on both sides of the high-power switch 302 are coupled to the source 314 through a first capacitor 362. The body is Direct Current (DC) biased through the resistor 368. The capacitance of the first capacitor 362 between the source 314 and the body electrode 324 is selected to balance the voltage between the source 314 and the body electrode 324. While one first capacitor 362 is shown, there may be multiple first capacitors to support multiple connections from the body electrode 324 to the source 314. A second capacitor 364 is coupled between the DNW electrode 330 and the substrate electrode 342. The second capacitor 364 reduces the voltage stress across the outer moat 308. The capacitors may be configured to have values to fully mitigate stress across the well junction. In some examples the capacitors are structured as metal-oxide-metal (MOM) capacitors, however other structures may be used to suit different performance, cost, and fabrication process requirements.

A resistor 368 is coupled between the substrate electrode 342 and the body electrode 324. Fig. 3 is a cross-sectional diagram in which the substrate electrode 342 and the body electrode 324 enclose all four sides of the high-power switch 302. Accordingly, there may be multiple resistors or an elongated resistor to connect the substate electrode 342 and the body electrode 324 at multiple locations or along a line. Similarly, the first capacitor 362 and the second capacitor 364 may also have multiple instances or connect along lines. The resistor 368 allows DC voltage to pass between the inner P-Well 318 and an outer P-Well 346 opposite the inner moat 306 and the outer moat 308. The DC voltage biases the voltage swing across the well junctions.

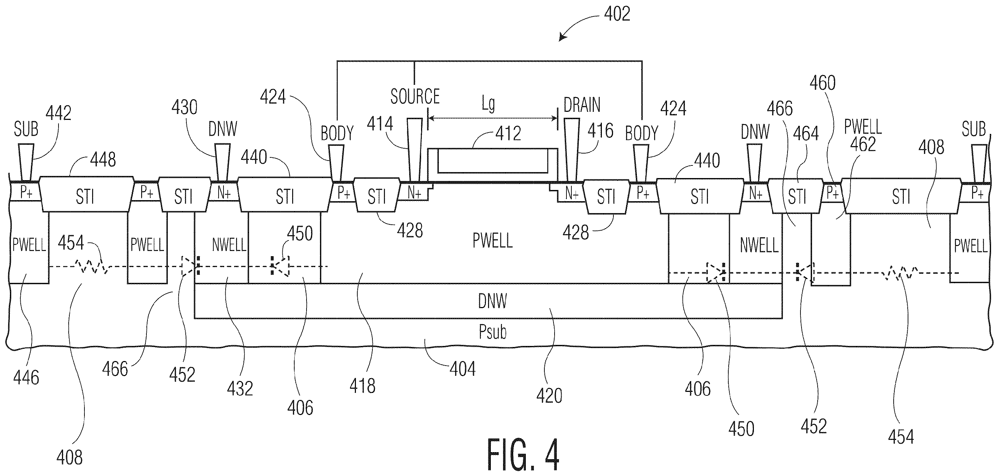

Fig. 4 is a cross-sectional diagram of a high-power switch with a deep N-well (DNW) and a triple blocking mask to create a second floating P-Well for a high-power switch. The high-power switch 402 is a semiconductor switch formed as an NMOS FET on a p-type substrate 404. An inner moat 406 surrounds the high-power switch, and an outer moat 408 surrounds the inner moat 406. The high-power switch is shown as an N-type planar Complementary Metal-Oxide Semiconductor (CMOS) transistor. As in Fig. 2, a planar configuration is shown, however, the configuration may be adapted for other configurations including FinFET. In addition, additional NMOS FET structures may be formed over the high-power switch 402 to increase the current carrying ability.

The high-power switch 402 has a gate 412 over an inner well, e.g. an inner P-well 418. The gate 412 is configured between an n-type source 414, that is N+ doped, and an n-type drain 416, that is N+ doped. The gate 412, source 414, and drain 416 are over the inner P-Well 418, which is over a DNW 420 which is over the p-type substrate 404. A p-type body electrode 424 is formed of a P+-doped contact coupled to the inner P-Well 418 around the source 414, drain 416 and gate 412 over the inner P-Well 418 and isolated from the source 414 and gate 412 by a STI layer over the inner P-Well 418 and around the source 414, drain 416, and gate 412. The source 414 and the drain 416 may be coupled to higher layers and external components through electrodes consisting of silicided material, conductors or metal vias. Additional dielectric and conductive layers may be formed over the structures shown herein to provide electrical and thermal coupling and control. For a FinFET implementation, the source 414 and the drain 416 may be configured as fins with the gate and otherwise adapted to suit the particular architecture.

The inner P-Well 418 is isolated by an inner moat 406 that extends all around the inner P-Well 418 and down to the DNW 420. The inner moat 406 is formed in the P substrate with P substrate material with little to no doping. An n-type DNW electrode 430 is formed of an N+-doped contact outside of the inner moat 406 over an N-Well 432 that extends to the DNW 420. The DNW is then isolated by an outer moat 408 that extends all around the DNW 420 and the inner moat 406. A p-type substrate electrode 442 is formed of a P+-doped contact outside of the outer moat 408 over an outer well, e.g. an outer P-Well 446 that extends into the P substrate 404 outside the outer moat 408. A surface STI layer 440 isolates the body electrode 424 from the DNW electrode 430 over the inner moat 406. A second surface STI layer 448 isolates the DNW electrode 430 from the substrate electrode 442 over the outer moat 408. The inner moat 406 and the outer moat 408 may be undoped regions of the P substrate 404 or a similar substrate material between the respective doping wells of the body electrodes 424, the DNW electrodes 430 and the substrate electrodes 442. The inner moat 406 and the outer moat 408 allow lateral implant diffusion and wider depletion width in the substrate.

With the triple blocking mask, a floating P-Well 462 is formed between the inner N-Well 432 and the outer P-Well 446. The floating P-Well 462 is within the outer moat 308 as shown in Fig. 3 to divide the outer moat 454 into two parts, the outer moat 454, and a middle moat 466 of P substrate between the floating P-Well 462 and the N-Well 432. A p-type substrate electrode is formed of a P+-doped contact 460 within the outer moat 408 over the floating P-Well 462 that extends into the P substrate 404 within the outer moat 408 to divide the outer moat 408. A surface STI layer 464 isolates the DNW electrode 430 from the P+ doped contact over the floating P-Well 434 over the inner moat 406. The inner P-Well 418, the inner moat 406, and the N-Well 432 form a second effective diode 452 to prevent current flow through the P substrate from the N-Well 432 through the third block, the outer moat 408. The width of the outer moat 408 may be adapted to suit different electrical characteristics for an effective triple block.

The body electrodes 424 on both sides of the high-power switch 402 are coupled to the source 414. The connection applies a Direct Current (DC) bias to the body, i.e. the inner P-Well 418. The P+ contact of the body electrode 424, the N+ contact of the source 414, the STI layer 440 and the block between the two may be adjusted in dimensions and characteristics to obtain an appropriate intrinsic capacitance between the source 414 and the body electrode 424. Alternatively, the body electrode 424 may be coupled to a different voltage source to apply an appropriate DC bias to the body.

As in Fig. 2, the inner P-Well 418, inner moat 406, and N-Well 432 form a first effective diode 450 with an anode at the inner P-Well 418 and a cathode at the N-Well 432 and a body in the inner moat 406 that is formed of the material of the P substrate 404. The first effective diode 450 is represented in Fig. 1 as the first diode 132. In this example, an N-Well 432, the outer moat 408, and the outer P-Well 446 form a second effective diode 456 with opposite polarity. The anode of the second effective diode 452 is at the floating P-Well 462 and the cathode of the second effective diode 452 is at the N-Well 432. The first effective diode 450 is represented in Fig. 1 as the first diode 13w. The larger width and depth of the outer moat 408 forms the effective resistor that is represented in Fig. 1 as resistor 136.

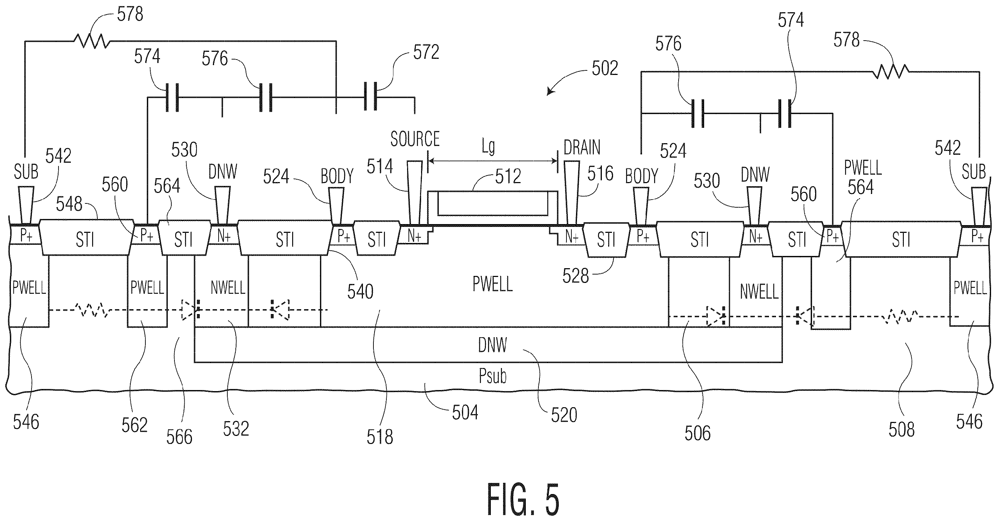

The width of the inner moat 406 and the middle moat 466 may be selected and configured to provide a capacitance across the N-Well 230. The value of the capacitance may be determined so as to avoid an external capacitor. Alternatively, the width of the inner moat 406 and the outer moat 408 may be selected to optimize packaging and external capacitors may be used, as shown e.g. in Fig. 5, to provide the desired characteristics. With the middle moat 466, the well junction capacitance may be determined independently of the characteristics and configuration of the outer moat 208. This allows the resistance and the capacitance to be optimized for a particular switch and switch application.

The additional block in the form of the middle moat 466 provides additional intrinsic regions between the inner P-Well 418 and the P substrate 404. These increase the performance of the high-power switch still further by permitting independent control of the intrinsic capacitance of the junction diode 452 and intrinsic substrate resistance 454. The triple blocking mask has a P substrate region in the inner moat 406, the outer moat 408 and the middle moat 466 better control the characteristics of the diode 452 and substrate resistance 454.

Fig. 5 is a cross-sectional diagram of a high-power switch with a deep N-well (DNW) and a triple blocking mask as in Fig. 4 with added balancing capacitors and isolation resistors. The high-power switch 502 is formed as an NMOS FET on a p-type substrate 504. An inner moat 506 surrounds the high-power switch and an outer moat 508 in the form of a resistive area surrounds the inner moat 506, an N-Well 532, and the DNW 520. The high-power switch is shown as an NPN planar Complementary Metal-Oxide Semiconductor (CMOS) transistor. As in Fig. 2, a planar configuration is shown, however, the configuration may be adapted for other configurations including FinFET. In addition, additional NMOS FET structures may be formed over the high-power switch 502 to increase the current carrying ability.

The high-power switch 502 has a gate 512 over a P-well 518. The gate 512 is configured between an n-type source 514, that is N+ doped, and an n-type drain 516, that is N+ doped. The gate 512, source 514, and drain 516 are over the inner P-Well 518, which is over a DNW 520 which is over the p-type substrate 504. A p-type body electrode 524 is formed of a P+-doped contact coupled to the inner P-Well 518 around the source 514, drain 516 over the inner P-Well 518 and isolated from the source 514 and gate 512 by an STI layer over the inner P-Well 518 and around the source 514, drain 516, and gate 512. The source 514 and the drain 516 may be coupled to higher layers and external components through electrodes consisting of polysilicon conductors or metal vias. Additional dielectric and conductive layers may be formed over the structures shown herein to provide electrical and thermal coupling and control.

The inner P-Well 518 is isolated by an inner moat 506 that extends all around the inner P-Well 518 and down to the DNW 520. The inner moat 506 is formed in the P substrate with the P substrate material, e.g. using a native layer process. An n-type DNW electrode 530 is formed of an N+-doped contact outside of the inner moat 506 over an N-Well 532 that extends to the DNW 520. The DNW 520 is then isolated by a third block, a middle moat 566 that extends all around the DNW 520 and the inner moat 506. A p-type contact 560 is formed of a P+-doped contact over a floating P-Well 562 that extends into the P substrate 504 outside the DNW 520. A third surface STI layer 564 isolates the p-type contact 560 from the DNW electrode 530 over the middle moat 566. The DNW 520 is then isolated by an outer moat 508 that extends all around the floating P-Well 562. Another p-type substrate electrode 542 is formed of a P+-doped contact outside of the outer moat 508 over an outer P-Well 546 that extends into the P substrate 504 outside the outer moat 508.

A second surface STI layer 540 isolates the body electrode 524 from the DNW electrode 530. A third STI layer 564 over the P substrate 504 isolates the p-type contact 560 from the body DNW electrode 530 And a fourth STI layer 548 over the outer moat 508 isolates the substrate electrode 542 from the p-type contact 560. The three moats 506, 566, 508 may be undoped regions of the P substrate 504 between the respective doping wells of the body electrodes 524, the DNW electrodes 530, the p-type contacts 560, and the substrate electrodes 542. The three moats 506, 566, and 508 allow lateral implant diffusion and still wider depletion width in the substrate.

The body electrodes 524 on both sides of the high-power switch 502 are coupled to the source 514 through a first capacitor 572. The capacitance of the first capacitor 572 between the source 514 and the body electrode 524 is selected to balance the voltage between the source 514 and the body electrode 524. While one first capacitor 572 is shown, there may be multiple first capacitors to support multiple connections from the body electrode 524 to the source 514. A second capacitor 574 is coupled between the DNW electrode 530 and the p-type contact 560. The second capacitor 574 reduces the voltage stress across the middle moat 566. The capacitors may be configured to have values to fully mitigate stress across the well junction. In some examples the capacitors are structured as metal-oxide-metal (MOM) capacitors, however other structures may be used to suit different performance, cost, and fabrication process requirements.

A resistor 578 is coupled between the substrate electrode 542 and the body electrode 524. Fig. 5 is a cross-sectional diagram in which the substrate electrode 542 and the body electrode 524 enclose all four sides of the high-power switch 502. Accordingly, there may be multiple resistors or an elongated resistor to connect the substate electrode 542 and the body electrode 524 at multiple locations or along a line. Similarly, the first capacitor 572 and the second capacitor 574 may also have multiple instances or connect along lines. The resistor 568 allows DC voltage to pass between the inner P-Well 518 and an outer P-Well 546 opposite the inner moat 506 and the outer moat 508. The voltage biasing balances the voltage swing across the well junctions. Additional capacitors and resistors may be used in this and the example of Fig. 3. The particular connections are provided as suitable examples of how voltage conditions may be controlled using additional resistors and capacitors.

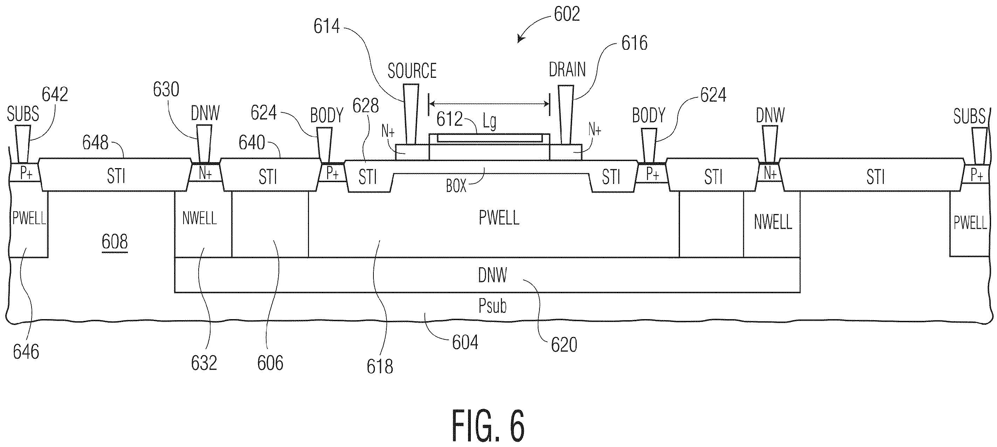

Fig. 6 is a cross-sectional diagram of a high-power switch in the form of an NMOS transistor formed in FDSOI technology over a DNW with a double blocking mask to increase the avalanche breakdown voltage of the high-power switch. The high-power switch 602 is a semiconductor switch formed as an NMOS FET on a p-type substrate 604. An inner moat 606 surrounds the high-power switch and an outer moat 608, i.e. a resistance moat, surrounds the inner moat 606, an N-Well 632, and the DNW 620. While only one NMOS FET is shown, additional NMOS FET structures may be formed over the high-power switch 602 to increase the power handling ability of the high-power switch 602.

The high-power switch 602 has a gate 612 with an undoped channel over a buried oxide (BOX) layer. The channel may be formed of a undoped Si, SiGe or another compound material. The BOX layer is over an inner well, e.g. an inner P-well 618. The gate 612 is configured between an n-type source 614, that is N+ doped, and an n-type drain 616, that is N+ doped. The gate 612, source 614, and drain 616 are over the BOX layer, that is over the inner P-Well 618, which is over a DNW 620 which is over the p-type substrate 604. The inner P-Well 618 may be used underneath this transistor. A DNW 620 is fabricated below the inner P-Well 618 to isolate the device against the p-type substrate 604.

A p-type body electrode 624 is formed of a P+-doped contact coupled to the inner P-Well around the source 614, drain 616 and gate 612 over the inner P-Well 618 and isolated from the source 614 and gate 612 by a Shallow Trench Isolation (STI) layer over the inner P-Well 618. The STI 628 may be contiguous with the BOX layer and between the channel and the inner P-Well 618. The source 614 and the drain 616 may be coupled to higher layers and external components through electrodes consisting of silicide contacts and metal vias.

The sidewall of the inner P-Well 618 is separated from the DNW 620 by an inner moat 606 of P substrate or a similar substrate material that surrounds, or extends all around, the inner P-Well 618 and down to the DNW 620. In examples the inner moat 606 is formed in the P substrate with a native layer process to block P-type doping into the inner moat 606 when forming P-Wells and N-Wells. An n-type DNW electrode 630 is connected to the N-Well 632 through an N+-doped contact outside of the inner moat 606 and over the N-Well 632. The N-Well 632 extends to the DNW 620. The DNW is then isolated by an outer moat 608 that surrounds and extends all around the DNW 620, the N-Well 632, and the inner moat 632. A p-type substrate electrode 642 is formed of a P+-doped contact outside of the outer moat 608 over an outer well, e.g., an outer P-Well 646 that extends into the P substrate 604 outside the outer moat 608. A surface STI layer 640 isolates the body electrode 624 from the DNW electrode 630 over the inner moat 606. A second surface STI layer 648 isolates the DNW electrode 630 from the substrate electrode 642 over the outer moat 608. The inner moat 606 and the outer moat 608 may be undoped regions of the P substrate 604 between the respective doping wells of the body electrodes 624, the DNW electrodes 630 and the substrate electrodes 642. The inner moat 606 and the outer moat 608 allow lateral implant diffusion and wider depletion width in the substrate.

The inner P-Well 618, inner moat 606, and N-Well 632 form an effective diode as described above and the second block, which is the outer moat 608, forms a second effective diode 652 with opposite polarity. The outer moat 608 has a native substrate layer region that provides a high substrate resistance as described above. External diodes, capacitors, and resistors may be added to obtain desired values as described above.

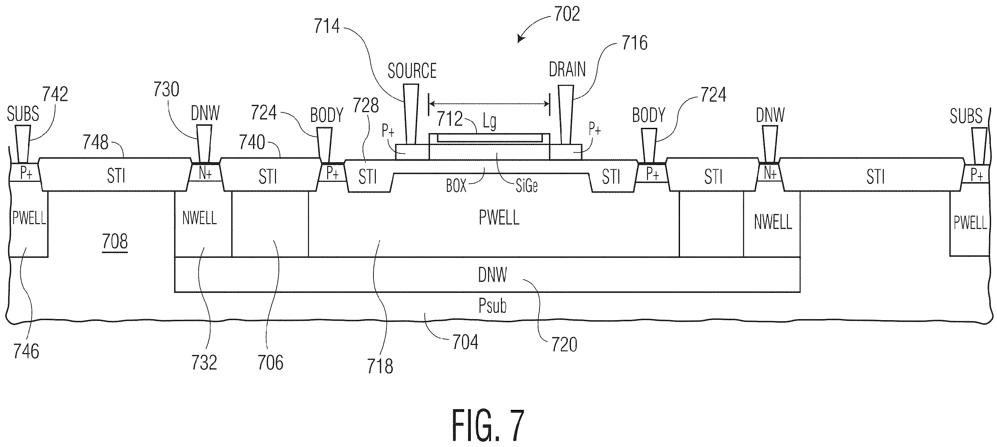

Fig. 7 is a cross-sectional diagram of a high-power switch in the form of a PMOS transistor formed in FDSOI technology over a DNW with a double blocking mask to increase the avalanche breakdown voltage of the high-power switch. The structure of Fig. 7 is the same as that of Fig. 6 except for the channel and the source and drain contacts. The high-power switch 702 is formed as a PMOS FET on a p-type substrate 704. The high-power switch 702 has a gate 712 over an intrinsic undoped channel over a BOX layer, over a P-well 718. The channel may be formed of undoped material like Si, Silicon Germanium (SiGe) or other compound material. The gate 712 is configured between an p-type source 714, that is P+ doped, and an p-type drain 716, that is P+ doped.

An inner moat 706 surrounds the high-power switch, and the inner P-Well 718. An outer moat 708 surrounds the inner moat 706, an N-Well 732 and the DNW 720. A p-type body electrode 724 is formed of a P+-doped contact coupled to the inner P-Well around the source 714, drain 716 and gate 712 over the inner P-Well 718. The body electrode 724 is isolated from the source 714 and gate 712 by a STI layer 728 over the inner P-Well 718. The STI layer extends to the BOX layer under the source 714, drain 716, and gate 712 and over the inner P-Well 718. As in the example of Fig. 6, there may be more or fewer components over and beside those shown.

The high-power switch has a double P-Well block. The inner P-Well 718 is isolated by an inner moat 706 that extends all around the inner P-Well 718 and down to the DNW 720. The DNW 720 is further isolated by an outer moat 708 that extends all around the DNW 720 and the inner moat 706. A p-type substrate electrode 742 is formed of a P+-doped contact outside of the outer moat 708 over an outer P-Well 746 that extends into the P substrate 704 outside the outer moat 708. An n-type DNW electrode 730 is connected to an N-Well 632 between the inner moat 406 and the outer moat 708 through an N+-doped contact outside of the inner moat 606 and over the N-Well 632. The N-Well 632 extends to the DNW 620.

A surface STI layer 740 isolates the body electrode 724 from the DNW electrode 730 over the inner moat 706. A second surface STI layer 748 isolates the DNW electrode 730 from the substrate electrode 742 over the outer moat 708. The inner moat 706 and the outer moat 708 allow lateral implant diffusion and wider depletion width in the substrate. As in the example of Fig. 2, additional dielectric and conductive layers may be formed over the structures shown herein to provide electrical and thermal coupling and control.

While the high-power switch is described in the context of a transmit/receive switch for a radio transceiver, the high-power characteristics may be beneficial for many other applications. The double and triple blocking features may be used to provide electrostatic discharge protection to transistor switch and diodes. High voltage AC tuning switches may be protected by double and triple blocking features. Boost converter and buck converters constructed from series of transistor switches may be protected by the double and triple blocking features described herein. The double and triple blocking features may also be used to protect a source follower from parasitic capacitance or to isolate transistors from noise in a substrate, e.g., from a nearby amplifier.

Although the configurations of the structures herein are shown and described in a particular order, the order of the structures of each example may be altered and additional component may be added to add additional operations or functionality that may be performed in addition to the operations and functions described herein.

Embodiments of the invention may be implemented entirely in hardware or in an implementation containing both hardware and software elements. In embodiments which use software, the software may include but is not limited to firmware, resident software, microcode, etc.

Although specific embodiments of the invention have been described and illustrated, the invention is not to be limited to the specific forms or arrangements of parts so described and illustrated. The scope of the invention is to be defined by the claims appended hereto and their equivalents.

## Claims

1. A semiconductor switch comprising:
a substrate of a first type having a top surface over a bottom surface that is opposite the top surface;
a deep well of a second type over the substrate;
an inner well of the first type over the deep well;
a gate over the top surface and over the inner well;
a source over the inner well having a contact of a second type coupled to the gate through the inner well;
a drain over the inner well having a contact of the second type coupled to the gate through the inner well;
a body electrode over the inner well having a contact of the first type coupled to the gate through the inner well;
an inner moat outside of the inner well and over the deep well surrounding the gate, the source, the drain, and the body electrode;
a deep well contact outside of the inner moat and over the deep well having a contact of the second type and a contact well of the second type, the contact well surrounding the inner well, wherein the gate, the source, the drain, the body electrode, and the inner moat are over the deep well; and
an outer moat outside the deep well over the substrate and surrounding the contact well.

2. The semiconductor switch of claim 1, wherein the inner moat and the outer moat are comprised of a substrate material of the first type.

3. The semiconductor switch of claim 1 or 2, wherein the deep well is a deep N-Well, the inner well is a P-Well, and wherein the inner moat and the outer moat comprise p-type substrate.

4. The semiconductor switch of any preceding claim, wherein the body electrode is coupled to the source.

5. The semiconductor switch of any preceding claim, further comprising an isolation layer over the inner moat and over the outer moat.

6. The semiconductor switch of claim 5, wherein the isolation layer comprises a shallow trench isolation layer.

7. The semiconductor switch of any preceding claim, wherein the inner moat is configured as an effective diode with an anode at the inner well and a cathode at the contact well to increase a breakdown voltage of the semiconductor switch in the deep well.

8. The semiconductor switch of any preceding claim, wherein the outer moat is configured as an effective diode with a cathode at the contact well to increase the breakdown voltage of the semiconductor switch.

9. The semiconductor switch of any preceding claim, further comprising a substrate electrode outside of the outer moat and an outer well of the first type over the substrate, the outer well surrounding the outer moat.

10. The semiconductor switch of claim 9, wherein the body electrode is coupled to the substrate electrode, the semiconductor switch further comprising a capacitor coupled between the body electrode and the source configured to balance the voltage between the body electrode and the source.

11. The semiconductor switch of claim 10, further comprising a second capacitor between the deep well contact and the substrate electrode configured to reduce voltage stress across the outer moat.

12. The semiconductor switch of any of claims 9 to 11, further comprising a floating well of the first type over the substrate inside the outer moat and outside of the contact well, the floating well to divide the outer moat into the outer moat and a middle moat.

13. The semiconductor switch of claim 12, wherein the body electrode is coupled to the substrate electrode and wherein the body electrode is coupled to the substrate electrode, the semiconductor switch further comprising:
a capacitor coupled between the body electrode and the source configured to balance a voltage between the body electrode and the source; and
a second capacitor between the deep well contact and the floating well.

14. The semiconductor switch of any preceding claim, wherein the gate comprises a channel of intrinsic doped silicon over a buried oxide layer, the buried oxide layer being over the inner well.
